# EUROPEAN PATENT APPLICATION

(11) **EP 1 400 904 A2**
(43) Date of publication of application: **24.03.2004**
(21) Application number: 03255368.7
(22) Date of filing: 29.08.2003
(51) Int. Cl.: G06F 17/50

(54) **Apparatus and method for synthesizing and designing circuits and filters**

(30) Priority: 29.08.2002 US 407265 P
(71) Applicant: Anadigm, Inc., Tempe, Arizona 85284 (US)
(72) Inventor: Anderson, Howard C., Tempe Arizona 85283 (US); Waters, Michael Andrew, Chandler Arizona 85224 (US)
(74) Representative: Lambert, Ian Robert

(57) **Abstract**

An apparatus is provided for designing a filter to be rendered on a programmable circuit device capable of realizing at least one filter design by wiring together at least one filter component. The apparatus includes a programmable computing device, a user interface, and a design tool. The user interface is associated with the programmable computing device. The design tool is associated with the programmable computing device and is configured for interaction with a user at the user interface. The design tool comprises computer program code embodied in the programmable computing device including at least one filter sub-circuit definition for rendering a filter design and containing information for defining at least one of multiple configurations, topologies, and parameters of the filter design via the at least one sub-circuit definition for a programmable circuit device. The user interface is configured to enable a user to select and apply input parameters to the filter design and dynamically receive display of at least one of filter response, poles required, and evaluation of sub-circuit parameters so a user can optimize input parameters for a desired filter design. A method is also provided.

## Description

### CROSS-REFERENCE TO RELATED APPLICATION

This application claims priority in U.S. Provisional Patent Application Serial No. 60/407,265, which was filed on August 29, 2002, and which is incorporated by reference herein.

### TECHNICAL FIELD

This invention pertains to programmable and configurable devices. More particularly, this invention relates to filter circuit design using a user interface that enables configuration of filter characteristics.

### BACKGROUND OF THE INVENTION

Traditional filter design is a batch process, a set of specifications is defined, and calculations are made based on those specifications to derive filter response equations. The filter response equations are then used to derive actual component values. Alternatively, in the case of a switched capacitor realization the filter response equations are used to derive a set of parameters for each stage of the filter.

The design equations are complicated and time consuming. Many filter designs are unrealizable because of component limitations. In such cases, the filter needs to be redesigned with a new specification.

Currently available filter design software (such as Filter Wiz Pro, by Schematics Software of Sooke, British Columbia, Canada, and Filter Lab, by Mentor Graphics of Wilsonville, Oregon) automates calculations and presents plots of filter response, but inputs need to be entered for each "run", essentially a "batch" operation which is run one step at a time based on user inputs to the computer terminal. The same steps are still required for the filter design using these methods as when using manual calculations, a slide rule, or a calculator; only the speed of solving the equation, the ease of entering the information, and the presentation of the results has changed. The result is a vast improvement over pre-computer methods for solving the problem, but the designer's methodology is essentially unchanged.

Accordingly, improvements are needed in enabling a designer of a filter design realization to quickly and easily see the consequences to a filter design realization when making incremental changes to filter parameters.

### SUMMARY OF THE INVENTION

An apparatus and method are provided for synthesizing a circuit realization using a circuit performance prediction that is rendered perceptible by a user so the user can interact with the circuit performance prediction to change parameters and, in response, perceive an updated circuit performance prediction. In one case, the circuit realization is a filter realization.

According to one aspect, an apparatus is provided for designing a filter to be rendered on a programmable circuit device capable of realizing at least one filter design by wiring together at least one filter component. The apparatus includes a programmable computing device, a user interface, and a design tool. The user interface is associated with the programmable computing device. The design tool is associated with the programmable computing device and is configured for interaction with a user at the user interface. The design tool comprises computer program code embodied in the programmable computing device including at least one filter sub-circuit definition for rendering a filter design and containing information for defining at least one of multiple configurations, topologies, and parameters of the filter design via the at least one sub-circuit definition for a programmable circuit device. The user interface is configured to enable a userto select and apply input parameters to the filter design and dynamically receive display of at least one of filter response, poles required, and evaluation of sub-circuit parameters so a user can optimize input parameters for a desired filter design.

According to another aspect, a method is provided for designing a circuit using a programmable circuit device. The method includes: providing a programmable computer with a user interface, a design tool and sub-circuit definitions for filter circuit components; with the programmable computer and the user interface, generating a filter performance prediction; applying one or more input parameters to the filter performance prediction via the user interface; and displaying at least one of filter response, poles required, and evaluation of sub-circuit parameters in response to a change in input parameters.

According to yet another aspect, a method is provided for synthesizing a circuit approximation. The method includes: providing a user interface, a programmable computing device, and a circuit design tool associated with the programmable computing device and configured to interact with a user via the user interface; selecting a type of circuit to be synthesized; selecting a circuit approximation; rendering a circuit performance prediction via the design tool and programmable computing device based at least in part on a circuit parameter; and dynamically interacting with the circuit performance prediction via the user interface to adjust the circuit parameter.

### BRIEF DESCRIPTION OF THE DRAWINGS

Preferred embodiments of the invention are described below with reference to the following accompanying drawings.
Fig. 1 illustrates a block diagram overview of a basic system configuration of an exemplary system for performing a programmable device, according to one embodiment of the present invention.
Fig. 2 is a diagram of a screen display for a default screen for a filter design tool within the design tool of Fig. 1 and illustrating an initial screen that is shown upon starting the filter design tool program.
Fig. 3 is a diagram of a screen display for the default screen of Fig. 2, but after the vertical pass band edge designator line has been dragged to 660 Hz.
Fig. 4 is a diagram of a screen display for the default screen of Figs. 1 and 2, but after the vertical pass band edge designator line has been dragged to 400 Hz.
Fig. 5 is a diagram of a screen display for the default screen of Figs. 1 and 2, but after the stop band attenuation designator line has been dragged from -30 dB to -50 dB.
Fig. 6 is a diagram of a screen display for a default filter using a Bessel approximation and showing the characteristic constant change of phase with frequency, but distorted by log/log graph scaling.
Fig. 7 is a diagram of a screen display for the default filter using a Bessel approximation of Fig. 6, but showing the constant group delay value up to the designated corner frequency which is characteristic of a Bessel approximation filter.

### DETAILED DESCRIPTION OF THE PREFERRED EMBODIMENTS

This disclosure of the invention is submitted in furtherance of the constitutional purposes of the U.S. Patent Laws "to promote the progress of science and useful arts" (Article 1, Section 8).

In an effort to prevent obscuring the invention at hand, only details germane to implementing the invention will be described in great detail, with presently understood peripheral details being incorporated by reference, as needed, as being presently understood in the art.

With the introduction of modern computing methods, and especially personal computers, interactive computing methods have been developed which allow rapid optimization of highly complex problems. For example, a flight simulator program does much more than merely solve the complex equations of flight. The immediate feedback of an action and the action's effect on the motion of an aircraft can be used to enhance pilot training and evaluation of engineering changes in a great many ways. Often a situation such as the sequence of an airplane crash is investigated by simulating the last moments of the aircraft's flight. The simulation allows rapid evaluation of potential causes of the mishap and aids in selecting the most likely alternative. Interactive computing allows a level of optimization of parameters that is not achievable in other ways and allows this optimization to be achieved much more rapidly.

This invention uses drag and drop techniques that allow a circuit (or filter) designer to drag lines that define the input parameters of a circuit (or filter) to new values. For the case of a filter design, resultant filter response, poles required and evaluation of configurable analog module (CAM) parameters are displayed dynamically on a graphical user interface (GUI) as the designer changes an input parameter. This gives nearly instantaneous feedback to the designer and allows the designer to interact with changes in the input parameter and the effect that this parameter has on the filter response. As a result, the designer is able to quickly select an optimal input parameter for the desired filter application. It should be emphasized that this solution uses a combination of immediate feedback to the user along with rapid dynamic re-synthesis of a target system. The mechanism can also be applied to computer-aided design (CAD) and electronic design automation (EDA) systems in general.

For purposes of this disclosure, the term "sub-circuit" is understood to refer to a network of connected components available for use as a macro-component of a larger circuit. A sub-circuit can form part of a circuit, or an entire circuit. A circuit might contain multiple connected sub-circuits. For example, a superheterodyne receiver circuit comprises a radio-frequency (RF) amplifier sub-circuit, an oscillator sub-circuit, a mixer sub-circuit, an intermediate frequency (IF) amplifier sub-circuit, a detector sub-circuit, an audio amplifier sub-circuit, and a power supply sub-circuit that are connected together to form a complete superheterodyne receiver circuit.

For purposes of this disclosure, the term "field programmable analog array (FPAA)" is understood to refer to an integrated circuit capable of being programmed and configured to implement analog circuits using programmable interconnections and an array of configurable analog blocks. More particularly, an FPAA includes a collection of analog circuit components and switches. The switches are used to connect the components together in order to realize a particular circuit design. Switches are also used in order to set values of individual analog circuit components. By downloading a binary bitstream to the programmable device, or FPAA, the switches can be set in order to program the device, which in turn defines a particular circuit or sub-circuit on the device. Even relatively simple FPAAs have thousands of switches that need to be set in orderto realize a particular circuit design.

For purposes of this disclosure, the term "C" code as used herein refers to a specific example of program code. It is understood that other specific program codes could also be used including PASCAL, Visual Basic, or Fortran, as well as other known program codes.

For purposes of this disclosure, the term "user interface" as used herein is understood to refer to one or more of a combination of screen design, menus, command language, keyboard commands, and online help that is capable of rendering the way a user interacts with a computer. A user interface" may include a keyboard and/or a mouse, as well as any other input and/or output devices that enable a user to interact with a computer or a computer system. For example, both natural language recognition and voice recognition are considered to be included as standard components of some user interfaces.

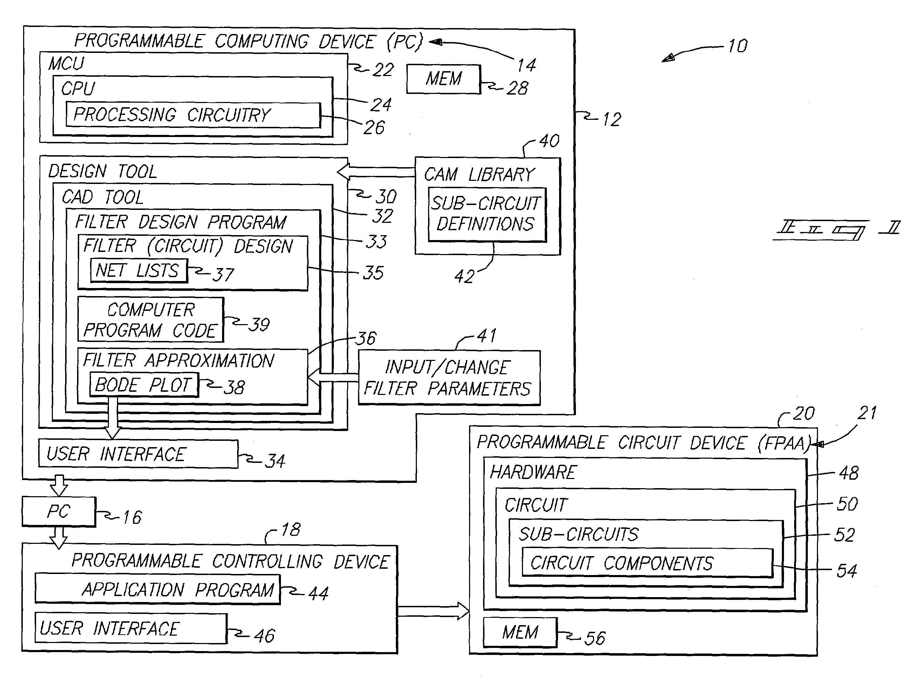

Figure 1 illustrates a preferred embodiment of Applicants' invention wherein a basic system configuration is provided for interacting with circuit design software to quickly and efficiently evaluate multiple different circuit realizations, parameters and specifications, such as a filter approximation, prior to programming a programmable circuit device, and is identified with reference numeral 10. For example, where the circuit is a filter, an interactive capability is provided to quickly and efficiently evaluate different filter approximations (Chebyshev, Butterworth, etc.), combinations of parameters that define the filter, and even different numbers of poles in the filter in order to enable the selection of an optimal design from a high level system viewpoint, rather than having to make such decision at a circuit level and component level viewpoint. System 10 includes a programmable computing device 12, such as a personal computer (PC) 14.

As shown in Figure 1, system 10 is implemented in a combination of software and hardware in a manner that enables eventual programming of programmable circuit device 20 using programmable controlling device 18 in order to realize a circuit (or filter) design. More particularly, software is provided in the form of exported device information for programming programmable circuit device 20 so that information that is required for close coupled control is made available for use in developing a controller program via a central processing unit (CPU) program. Programmable controlling device 18 then makes modified configuration data available to programmable circuit device 20 either by (a) modifying all or part of the configuration data, and then applying the configuration data to the registers within the programmable circuit device 20, or (b) directly modifying all or part of the configuration data contained within the registers of the programmable circuit device 20. Using configuration data, programmable circuit device 20 is programmed as a consequence of the software. Software aspects of the system generate, in addition to usual configuration data of presently available systems, code which may be used by a second configurable device in order to modify, in whole or in part, functionality of programmable circuit device 20.

As shown in Figure 1, programmable computing device 12 in oneform comprises a personal computer (PC) 14. PC 14 includes a micro-controller unit (MCU) 22, memory 28, a design tool 30, a user interface 34, and a configurable analog module (CAM) library 40. MCU 22 includes a central processing unit (CPU) 24 that includes processing circuitry 26. Design tool 30 includes a computer-aided design (CAD) tool 32 in which one or more filter (or circuit) designs 35 are generated and modeled. Each filter design 35 includes circuit model information in the form of netlists 37.

CAM library 40 includes a plurality of sub-circuit definitions 42 that contain information about respective sub-circuits. In one case, a sub-circuit definition is a configurable analog module (CAM). Accordingly, CAM library 40 comprises a plurality of CAMS. Programmable controlling device 18 includes an application program 44 and a user interface 46. In operation, application program 44 includes computer program code for implementing software monitoring and control functions within the associated application system. User interface 46 enables such monitoring and control functionality.

Programmable circuit device 20, in one form, comprises a field programmable analog array (FPAA) 21. FPAA 21 includes hardware 48 and memory 56. Hardware 48 is configurable via programming into multiple unique configurations. More particularly, a circuit 50 is realized within FPAA 21 by wiring or connecting together sub-circuits 52 and circuit components 54 into a desired configuration.

Design tool 30 comprises AnadigmDesigner2. An earlier version, AnadigmDesigner, is also publicly available for download and use at http://www.anadigm.com from Anadigm Ltd., United Kingdom, and is herein incorporated by reference. AnadigmDesigner2 includes aspects of the present invention which are added to the above-referenced earlier version of AnadigmDesigner, details of which are described below.

According to such techniques, the generation of programming data is greatly simplified using computer-aided design (CAD) tools. CAD tools represent the design in a manner that is familiar to a circuit designer, and which automatically generates corresponding data needed to program an FPAA. The ability to modify or generate such programming in the absence of such computer aided design tools is limited, and almost prohibitive. Additionally, CAD tool 32 enables the generation of a filter prediction, such as generating a Bode plot. Likewise, CAD tool 32 enables the dynamic generation of a filter performance prediction as a user manipulates one or more parameters for the filter approximation via a user interface (such as a graphical user interface) 34.

In operation, an initial set of configuration data is generated by design tool 30. Configuration data is provided via exported device information to a compiler (not shown) within PC 16. Additionally, or optionally, configuration data is provided via a user program (not shown) of PC 16 to the compiler. Further details of methods for configuring a programmable semiconductor device are disclosed in U.S. Patent No. 6,272,669 B1, entitled "Method for Configuring a Programmable Semiconductor Device", herein incorporated by reference. Additional details of an apparatus and method for configuring analog elements in a configurable hardware device are disclosed in U.S. Patent Application Serial No. 10/171,334, entitled "System and Method for Configuring Analog Elements in a Configurable Hardware Device", herein incorporated by reference.

CAD tool 32 includes a filter design program 33 configured for generating filter designs 35 having netlists 37. Filter design program 33 also includes a filter realization 36 that is rendered as a Bode plot 38 for displaying and interaction via user interface 34 with a user of the programmable computing device 12. In one case, filter realization 36 can be a Butterworth approximation, a Chebyshev approximation, an inverse Chebyshev approximation, an elliptic approximation, or a Bessel approximation. It is also understood that a filter can be one of several types, including a lowpass filter, a highpass filter, a bandpass filter, and a bandstop filter, depending on the filter realization. Furthermore, each filter realization can have one or more poles, and can be configured for implementation on one or more chips. Even furthermore, it is understood that a Bode plot can represent magnitude (dB) vs. frequency, phase vs. frequency, or magnitude vs. phase.

As shown in Figure 1, filter design program 33 further includes computer program code 39 that is embodied in programmable computing device 12 including at least one filter sub-circuit definition 42 for rendering a filter design 35 and containing information for defining at least one of multiple configurations, topologies, and parameters of the filter design 35 via the at least one sub-circuit definition 42 for implementation, subsequently, on the programmable circuit device 20. In operation, design tool 30 is associated with programmable computing device 12 and is configured for interaction with a user at user interface 34. Design tool 30 includes the computer program code 39. User interface 34 is then configured to enable a user to select and apply input parameters to a filter design 35 dynamically (and substantially simultaneously) receive display of at least one of filter response, poles required, and evaluation of sub-circuit parameters so a user can optimize input parameters for a desired filter design 35. It is understood that substantially simultaneously refers to a response that is less than a second in duration, and is preferably less than half a second in duration from receipt of the input parameter and delay of the response.

The specific improvements added to AnadigmDesigner2 over those presently available in publicly usable and commercially available AnadigmDesigner include the ability to interactively change parameters for a circuit design (orfilter design) and quickly view corresponding performance changes for the circuit at a user interface. The improvements also include the ability to design a circuit by assembling together a group of sub-circuit designs in a CAD tool. Once designed, the circuit (or sub-circuit) design can be realized in a programmable device, such as a field programmable analog array (FPAA). The CAD tool provides a mechanism for translating the circuit design into properly formatted data needed to program the device. Sub-circuit definitions for respective sub-circuits are compatible with the CAD tool, but are not an integral part of the CAD tool. The sub-circuit definitions are portable individually or in groups. More particularly, the sub-circuit definitions do not need to be compiled in order to use them with the CAD tool. Hence, the sub-circuit definitions can easily be created or modified to change functionality of the associated sub-circuit while still maintaining compatibility with the CAD tool.

The sub-circuit definitions contain information about the sub-circuit needed to do several things. First, they contain information about the sub-circuit needed to define multiple configurations, topologies, and parameters of the sub-circuit. Secondly, the sub-circuit definitions contain information about the sub-circuit needed to define and control the user interface that allows control of these multiple configurations. Thirdly, they contain information about the sub-circuit needed to modify the configuration of the sub-circuit based on user selections. Fourth, they contain information about the sub-circuit needed to provide error checking regarding the correct use of the sub-circuit. Fifth, they contain information about the sub-circuit needed to simulate the sub-circuit behavior within a larger analog circuit. Sixth, they contain information about the sub-circuit needed to draw a symbolic representation of the sub-circuit. Seventh, they contain information about the sub-circuit needed to determine the version number of the sub-circuit. Eighth, they contain information about the sub-circuit needed to determine the sub-circuit's compatibility with a particular CAD tool or version of a particular CAD tool. Ninth, they contain information about the sub-circuit needed to determine the sub-circuit's compatibility with a programmable device, such as an FPAA.

Some of the information about the sub-circuit is contained in the form of algorithms which may be realized in interpreter code. When the information in the algorithms is combined with data stored in the CAD tool and data taken from user interfaces run by the CAD tool, the algorithms return the desired information to the CAD tool. For example, information about modifying the configurations of the sub-circuit in response to user selections (item three, above) is handled in this manner.

CAD tool 32 (of Fig. 1) has the ability to do several things. First, it can read data contained in the sub-circuit definitions. Secondly, it can provide a user interface wherein the user can assemble the sub-circuits into larger circuits. Thirdly, it can provide a user interface for each sub-circuit so that a user can change the configuration and behavior of that sub-circuit design and quickly interact with resulting changes. Fourth, it can run interpreter code contained in the sub-circuit definitions. Fifth, it can provide a user interface with functionality that is specific to a particular programmable device. Sixth, it can set up and run a simulation using the circuit design and information contained in the sub-circuit definitions. Seventh, it can view the results of a simulation. Eighth, it can transform the circuit design into properly formatted data to download to a programmable device. Ninth, it can facilitate download of the properly formatted data to a programmable device.

The present implementation allows significant design expertise to be contained within the sub-circuit definitions, including sub-circuit topology, the relationship of sub-circuit topology and component values to higher level parameters displayed by the user interface, and sub-circuit performance as shown through simulation. The sub-circuit definitions, together with the CAD tool, contain specific details of the programmable device architecture. Accordingly, it is not required that a person utilizing this technique be an expert in circuit design or the programmable device. Instead, the user can work in a higher level of abstraction represented by the user interfaces of the sub-circuits and CAD tool. Hence, the design of circuits and the translation of circuits to a proper format for programming an FPAA chip is both relatively quick and easy.

Sub-circuit definitions, in the form of a configurable analog module (CAM), comprise a fully self-contained definition of one or more sub-circuits (or circuits) which can be configured in a programmable device, such as an FPAA chip. A sub-circuit definition includes "C" code that forms an integrated part of the sub-circuit definition, and interacts intimately with other sub-circuits. A CAM includes "snippets", or relatively small segments, of "C" code which define configuration, as well as a simulation model. The "snippets" of "C" code are not in the appended pieces of code, but require information from a CAM, including, but not limited to, clock frequency, clock phase, sampled input data, gain, and other items.

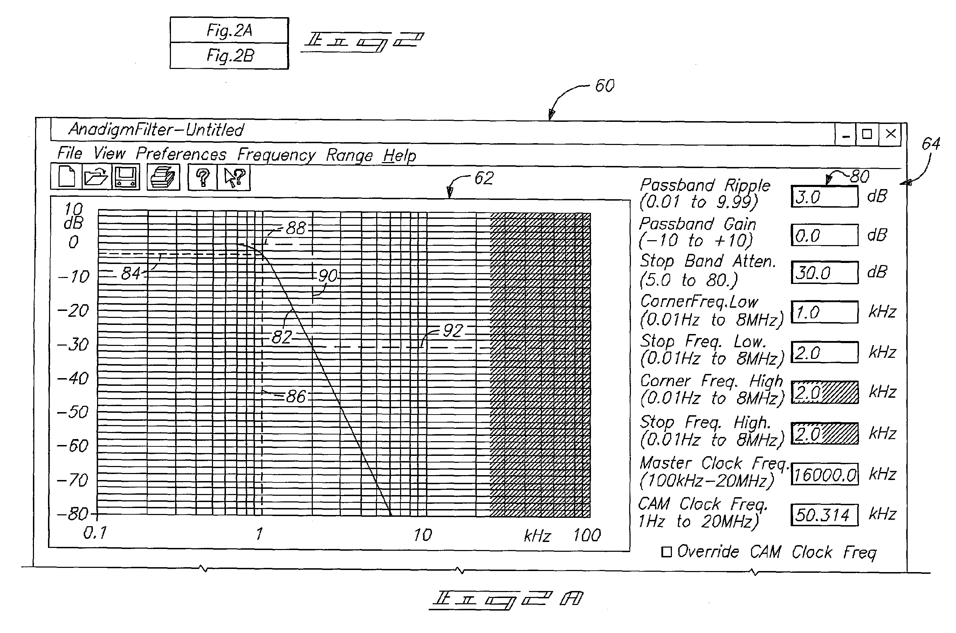

Figures 2-7 illustrate two filter designs depicting one possible implementation of the present invention. However, it is understood that other implementations having wider applicability for other circuit designs are also possible and fall within the scope of the appended claims.

Figure 2 illustrates the rendering of a circuit performance prediction by way of a Bode plot (magnitude vs. frequency response) of a five-pole lowpass filter generated using Anadigm filter design software of filter design program 33 (see Fig. 1). Such a filter might be useful in a stereo cross-over network system in order to separate out frequency ranges for unique, dedicated speakers on a stereo. The cross-over point can be customized using the filter design software in order to tailor the cross-over point to a custom environment, such as to optimize a specific automobile stereo system. The filter used in this example has a -3 decibel (dB) passband from 0 Hz to 1 KHz, and a maximum attenuation of -30 dB, 2 KHz outside the passband.

As shown in Figure 2, by starting the filter design program, a user can navigate to and is presented with a screen display that is depicted within a design tool application window 60. Window 60 is reached by selecting a menu item on a preceding screen display that is provided by the filter design program (not shown). A graph space 62 is configured to render a circuit performance prediction that is generated by the design tool in the programmable computing device based on input of one or more filter (or circuit) parameters. For the case where a circuit performance prediction is for a filter, a filter performance prediction is shown in the form of a Bode plot (or filter response) 82.

A number of unique filter parameters can be manipulated by a user at a user interface using "drag and drop" techniques to move various parameter lines 84-92 depicted in Figure 2 so that the user can dynamically interact with the filter performance prediction via the user interface to adjust the respective filter parameter and visualize changes to Bode plot 82. More particularly, the following parameter lines can be manipulated using "drag and drop" techniques: a ripple parameter line 84, a corner frequency parameter line 86, an overall gain parameter line 88, a stop frequency parameter line 90, and an attenuation parameter line 92. By selecting a respective parameter line using a cursor and a mouse, the parameter line can be "grabbed" and "dragged" by holding a mouse button and dragging the parameter line to a new desired value. In a nearly instantaneous response, a new filter response is calculated as reflected by a nearly instantaneous change to Bode plot 82 that represents a changed calculation of the Bode plot (for filter frequency response) as based upon a filter design calculation.

There exist a number of suitable filter design calculations that can be used in order to generate a Bode plot (or filter response). Classic examples are detailed in the textbook by Gobind Daryanami, Principles of Active Network Synthesis and Design, published by John Wiley & Sons, New York, @1976, Chap. 3, "Introductory Filter Concepts", and Chap. 4, "The Approximation Problem", herein incorporated by reference. However, there area number of other techniques for generating actual and approximate filter responses for plotting (such as for plotting a Bode plot). One is illustrated in the textbook by M.E. Van Valkenburg of the Department of Electrical Engineering at the University of Illinois at Urbana-Champaign, Analog Filter Design, published by Holt, Rinehart and Winston, Inc., @1982, available through Saunders College Publishing, Harcourt Brace Jovanovich College Publishers, Chap. 6, "Butterworth Lowpass Filters", and herein incorporated by reference. An even further example is set forth in the textbook by Les Thede of the Department of Electrical Engineering at Ohio Northern University, Analog and Digital Filter Design Using C, published by Prentice Hall PTR, Prentice-Hall, Inc., ©1996, Chap. 4, "Analog Frequency Response Calculation and Display", herein incorporated by reference. It is believed that such techniques are readily understood in the art and further details are being omitted herefrom in order to prevent obscuring the invention directly at hand. The above-referenced techniques calculate frequency response functions for filters using known transfer functions.

AnadigmFilter takes advantage of the processing power of modern computers to provide a "drag and drop" capability. This capability allows for instant feedback as a user of filter design software changes parameters by dragging the appropriate line on the plot with the cursor. As the limiting line is moved, the software continuously re-computes the filter response curve and generates a new response plot so that the movement of the line and the resultant plots appear to have a smooth motion. This allows a rapid and intuitive evaluation of the effects of changes to the parameter on the filter response characteristics.

This interactive capability can be used to "tweak" the filter parameters until a notch which is originally located at 375 Hz is moved up to 400 Hz. For a filter which is to be used in an avionics system this would now provide an extra 60 dB of attenuation at the avionics AC power supply frequency as a free bonus, just as the result of a slight adjustment in filter parameters.

In this way the interactive capabilities of the AnadigmFilter software allows the user to quickly evaluate many different filter approximations, combinations of parameters and even different numbers of poles in the filter so as to select the optimal design from the high level system viewpoint rather than having to be bogged down with circuit level and component level detail.

The screen display of design tool application window 60, as shown in Figure 2, also includes a parameter value space 64 into which a plurality of fields 80 show individual parameter values as identified by the respective parameter lines. For example, field 80 depicts "passband ripple" as identified by the ripple parameter line 84 of Figure 2. Other values are identified in respective fields as labeled within Figure 2.

Furthermore, application window 60 further includes a "Filter Type" 66 that has a plurality of radio buttons (such as Low Pass filter radio button 94). A (filter) "Approximation" field 68 is also provided that includes a plurality of filter approximations such as a Butterworth filter approximation identified by selection of Butterworth radio button 96. Each filter approximation includes a "Poles" field 98 that identifies the number of poles used with the specific selected filter. Furthermore, "Approximation" field 68 includes a "Chips" field 100 for each filter approximation that has been selected that identifies the predicted number of FPAA devices required for the specific selected filter approximation. Additionally, the "Plot" field 70 identifies the specific ordinate that is being plotted against frequency, such as magnitude (dB) identified by the "Magnitude" selection box 102. Furthermore, a "Dynamic Range Option" field 72 enables the ability to select a specific limiting instance where there exists a small signal. Furthermore, a "Build Circuit" button 74 and a "List CAMs" button 76 are also provided for respectively enabling building of a circuit and listing of associated CAMs. Finally, a "Filter Response" field 78 identifies the resulting characteristics of the lowpass filter identified by Bode plot 82 at a specific frequency selected by placement of a pointing device (such as a cursor) within graph space 62.

"Filter Response" field 78 includes text and information that gives exact values for frequency wherever a parameter line (or cursor) is positioned within graph space 62. The values are nearly instantaneous and continuously updated, as the cursor is moved right or left (or up or down) within graph space 62. As shown in Figure 2, the plot area represented above 25 KHz is shaded gray in order to indicate a "gray area" which identifies an area above a Nyquist limit for a clock frequency of 50 KHz.

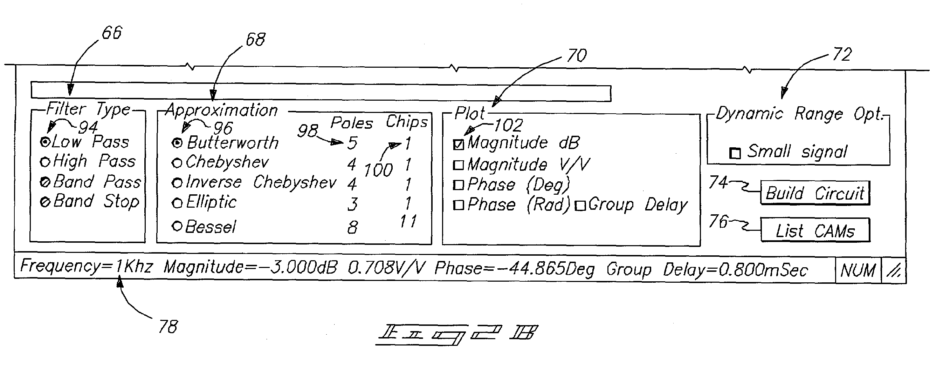

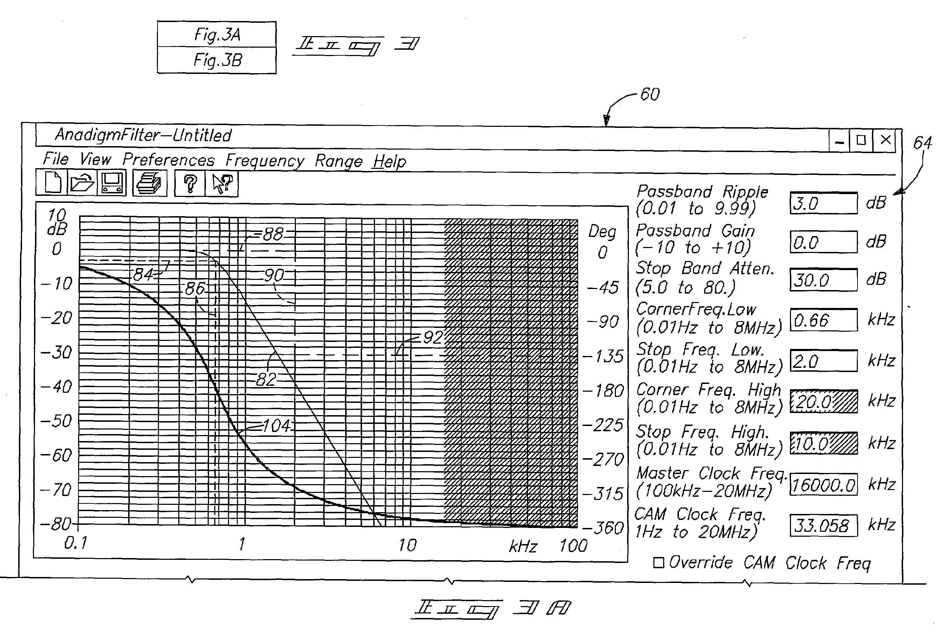

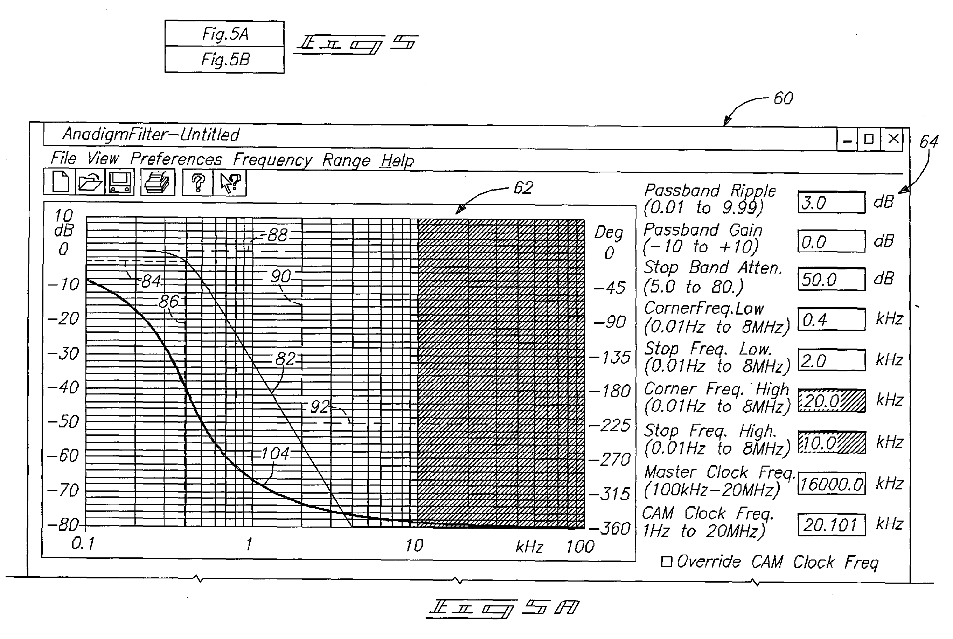

Figure 3 illustrates another screen display for the design tool application window 60 of Figure 2, but at a discrete, later period in time while a user is "dragging" the "corner frequency" parameter line (vertical passband edge designator line) 86 from 1 KHz to 660 Hz. Accordingly, parameter line 86 shows a snapshot during the "drag and drop" operation of moving parameter line 86 from a right position to a left position designated eventually in Figure 5. Bode plot 82 is shown in a recalculated configuration in response to the "drag and drop" operation. Accordingly, a user can dynamically interact with filter performance prediction via the user interface in order to judge the effects of an adjustment of a filter parameter on filter performance prediction. Corresponding changes are shown in fields 64, 68, and 70 that correspond with changes in the filter performance prediction and the filter parameters. Additionally, a filter phase performance plot 104 has been designated by selecting the appropriate check box in "Plot" field 70 to plot phase (and degree) vs. frequency to depict the corresponding filter performance prediction based upon changed or existing filter parameters. Accordingly, the phase performance of the newly configured filter design is depicted by plot 104. Correspondingly, the sized out gray area begins at a lower frequency value, starting at 16.5 KHz and reflecting the new clock frequency of 33 KHz. Additionally, the number of poles required for the subsequent filter has been reduced from five poles to four poles, as depicted within field 68. Such change occurs automatically, based upon the filter calculations used in generating the filter performance prediction as identified by Bode plot 82 in phase plot 104.

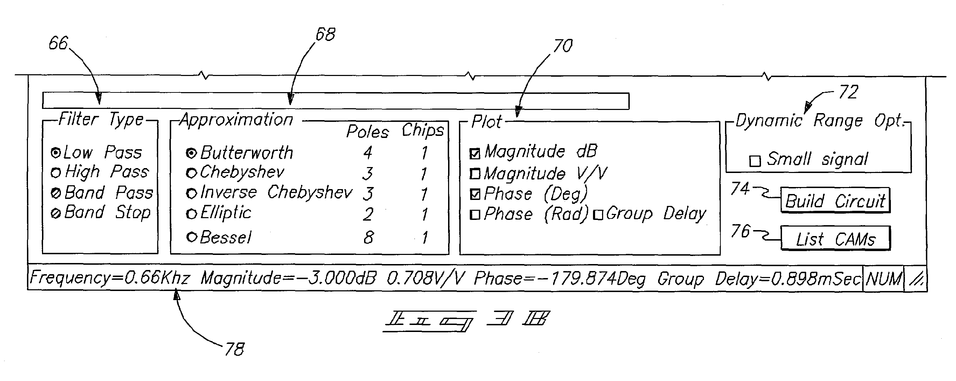

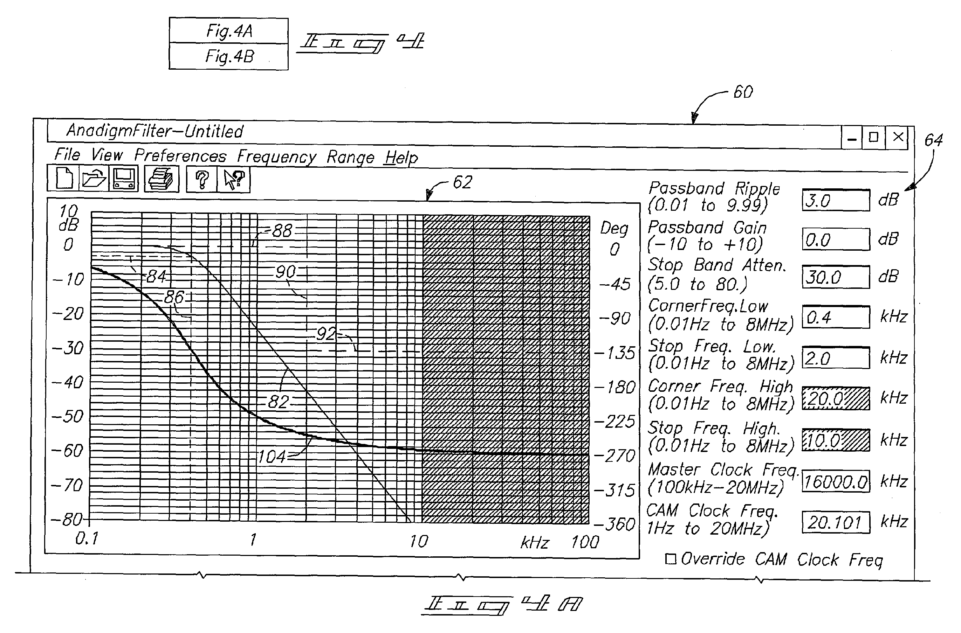

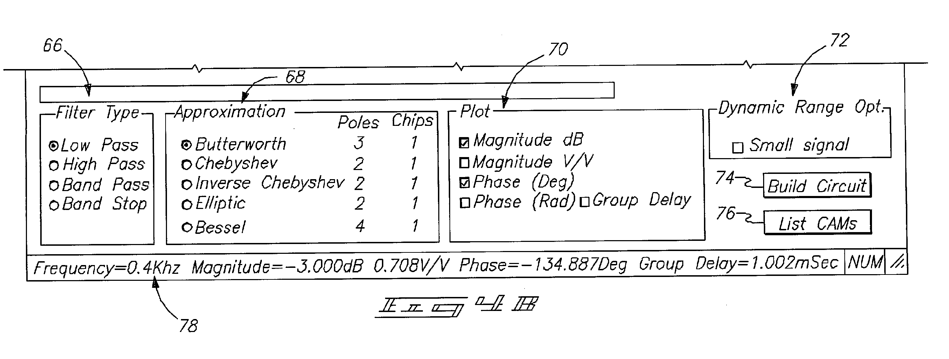

As shown in Figure 4, a screen display is depicted for design tool application window 60 later in time than that depicted in Figure 3, but during the same "drag and drop" operation for parameter line 86, as parameter line 86 is moved further to the left and towards the final location depicted in Figure 5. The parameter line 86 (vertical passband edge designator line) has been dragged to 400 Hz, and the gray area has moved to the left as far as 10 KHz, reflecting the new clock frequency of 20 KHz. The resulting reconfigured filter design now requires only three poles for a Butterworth approximation, as identified within "Approximation" field 86.

As shown in Figure 5, the screen displays provided for the design tool application window 60 show parameter line 86 moved to a final position during a "drag and drop" operation using a cursor and a mouse, by way of one example. Parameter 86, comprising a stopband attenuation, has now been dragged from -30 dB (see Fig. 4) to the resting position of -50 dB shown in Figure 5. The depicted gray area has not moved, since there is no change in clock frequency. However, the filter requires four poles for a Butterworth approximation, as shown within "Approximation" field 68. The cursor has also moved right to the 2 KHz frequency line, and thus shows the filter values at 2 KHz.

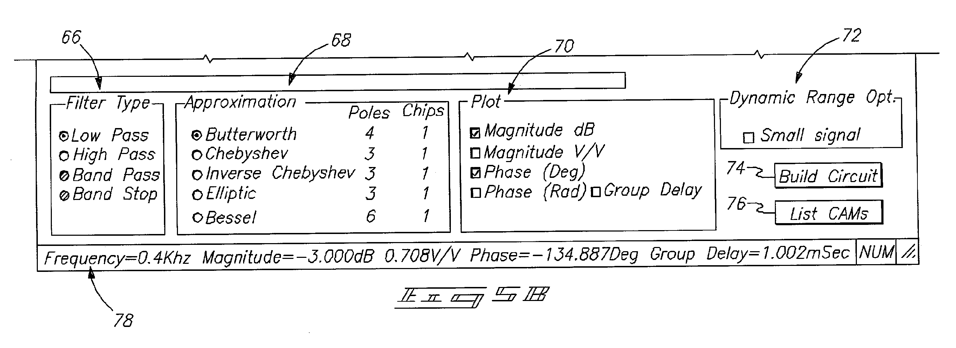

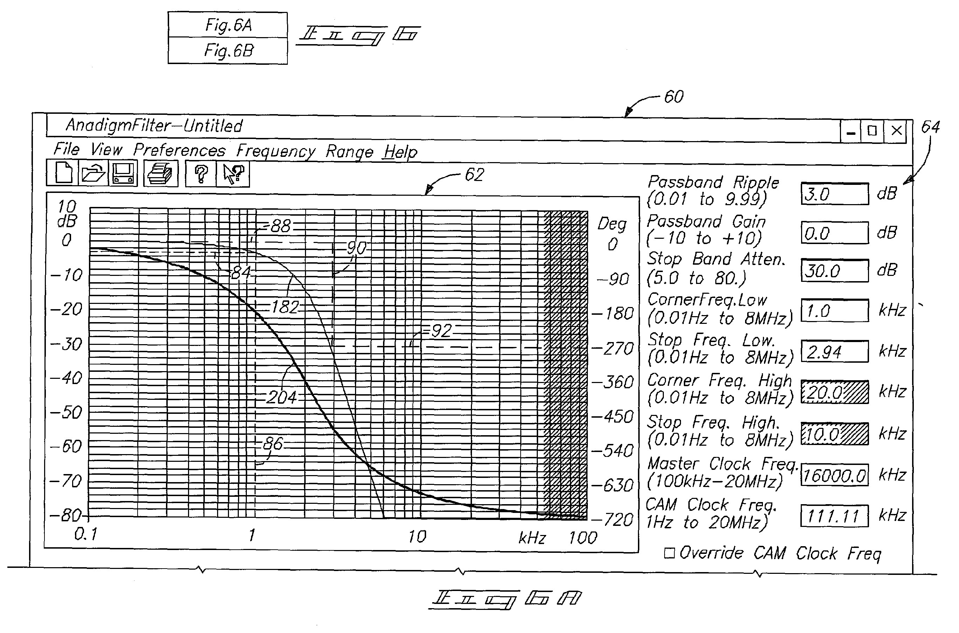

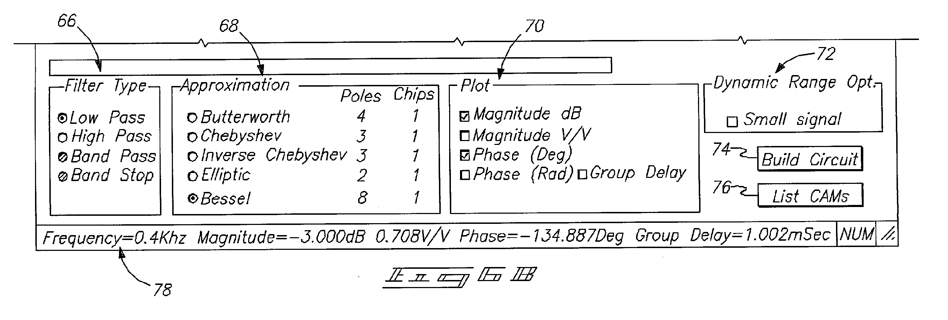

Figure 6 illustrates the rendering of another filter performance prediction using the design tool and programmable computing device of the present invention, and based at least in part on the changing of at least one filter parameter. Accordingly, a user can dynamically interact with the filter performance prediction via a user interface in order to adjust the filter parameter to reach a desired filter performance prediction. As shown in Figure 6, a selected filter approximation comprises a Bessel approximation, as identified in "Approximation" field 68. Within graph space 62, a Bode plot 182 and a phase plot 204 are shown corresponding with the positions of parameter lines 84-92. Such performance predictions also show the characteristic constant change of phase with frequency of a Bessel approximation, as distorted by log/log graph scaling. Corresponding values are identified in fields 64, 66, 68, and 70. Corresponding cursor position is also identified in field 78.

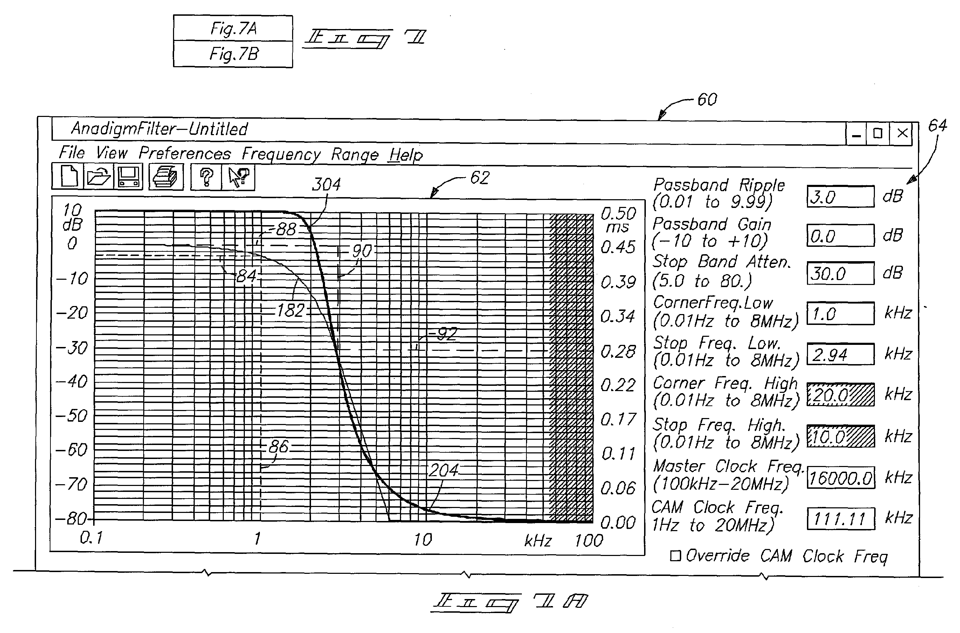

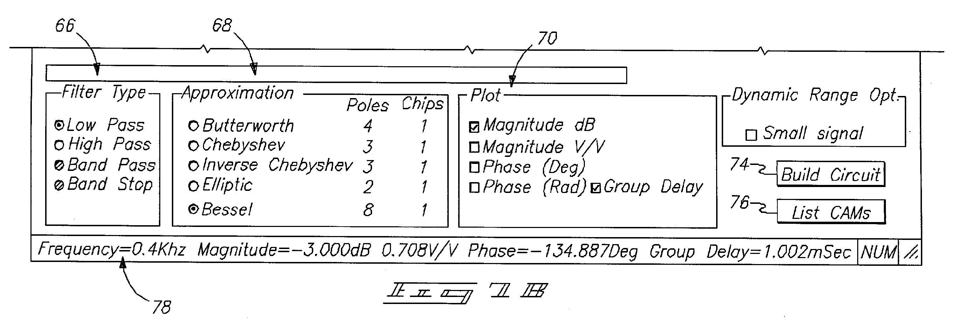

Figure 7 illustrates a screen display for the design tool application window 60, but eliminating the phase plot 204 (of Fig. 6) and adding a delay plot 304 showing a constant group delay value up to a designated corner frequency which is characteristic of a Bessel approximation filter.

According to the depictions in Figures 6 and 7, it is understood that filter performance prediction in the form of a Bode plot can be represented in three-dimensional space and parameter lines are merely two-dimensional visualizations that enable users to better visualize a filter performance prediction in response to selected input or changed filter parameters. However, it is understood that there are a number of different ways to view such a three-dimensional space in response to a certain filter design so as to better understand the inter-relationship between changes in filter parameters and resulting filter performance prediction.

The above-described filter design features can also take advantage of recent advances in programmable analog technology achieved by using Field Programmable Analog Arrays (FPAAs). Until recently, programmable analog really was just a novelty. The available technology just was not able to provide the performance which designers expect of modern analog devices. The FPAA has radically changed that situation.

The FPAA uses switched capacitor techniques to provide programmable analog capabilities which are at least comparable in performance to older switched systems such as digital signal processing (DSP) technology, but without the amplitude range and quantization limitations which are inherent with DSP technology.

In some respects the resultant performance of the FPAA is far superior to older technologies, since switched capacitor techniques take advantage of structures which can be fabricated reliably and repeatably when using modern CMOS chip fabrication processes.

The FPAA has extensive software support, an extensive library of analog functions implemented as "configurable analog modules" (CAMs), and a comprehensive design tool, AnadigmDesigner2, which takes care of the low level design tasks such as allocation of resources, placement, and interconnection of CAMS. Several high level design assistants are provided including AnadigmFilter which is a tool to facilitate design of complex multi-pole filters.

A major advantage of switched capacitor technology is that the filter parameters depend almost entirely on clock frequency so the resulting filters are extremely stable and repeatable over a wide range of temperatures and variations in device fabrication. In addition, this characteristic allows for easy tuning over a wide range by externally altering the clock frequency.

To use the FPAA approach, a user will start out just as in a traditional approach, by entering the filter specifications into AnadigmFilter, inspecting the Bode plots, and making changes as required until an acceptable design is achieved.

Once again, the same Bode plot can be seen as is shown in Figure 2 of the 5 pole bandpass filter generated by the AnadigmFilter filter design software. As before, the filter has a -3 dB passband from 0 Hz to 1 KHz, and a minimum attenuation of -30 dB, 2 KHz outside the passband.

At this point, however, rather than dividing the filter into biquadratic and bilinear stages and then starting to analyze each stage individually, the user merely "clicks" on the "Send Data" button located in the lower right corner of the screen to transfer the design to AnadigmDesigner2.

In a few seconds the transfer and analysis process is completed so AnadigmDesigner2 "pops" to the top of the user's screen almost exactly as shown in Figure 5. If desired, the user could now run a detailed simulation, add more circuit components, or make other modifications to the design.

In this example, a test board uses a different output from the default board so the output connection pin can be modified, to show how easy this is to do. It is actually faster to change the FPAA circuit internally than to change the external jumper pin on the evaluation board!

To do this, a user would right click on the blue wire leading to the output pin at the upper right corner and select delete. Next, the user would hold the cursor over the output pin of the filter; the cursor changes to a pen icon to indicate that AnadigmDesigner2 is in wiring mode. Now click on the pin of the output cell at the lower left corner of the chip to route the wire. This completes the rewiring and the final filter design shown. It takes longer to read this than it takes to do the wiring on the screen! Now a user can download the design to the evaluation board by clicking on the blue down arrow icon on the toolbar of AnadigmDesigner2.

The download from the Bode plot to operational silicon is completely automated, requiring only that the user initiate the transfer and make any changes that are desired along the way. At this point the user has working hardware for testing!

The advantage of this rapid design cycle is not merely in the saving of engineering time, although that is certainly significant, but reflects the fact that any truly innovative design work must of necessity incorporate a certain amount of trial and error. It is simply not possible to achieve optimal results the first time something new is tried. In practice the more trials, that is to say the more experience that can be gained with a new design, then the better the quality of the final design.

Experience in the digital design space using Field Programmable Gate Arrays (FPGAs) has shown that much of the benefit derived from rapid prototyping is derived from the ability to try out 20 or 30 designs rather than only two or three so as to select the optimal set of tradeoffs based on actual trials. It is fundamental that the further along the learning curve a user (or designer) can get, then the lower the risk that will be involved with any new design!

Once a user is ready to build a production version of a filter, an FPAA is provided which uses an SPI EEPROM to boot a single FPAA chip. If desired, the FPAA could also be used in many other configurations including various kinds of EEPROMs and embedded microprocessors as well as multiple FPAA chips.

A comparison of the tabulated measured values with equivalent values predicted by AnadigmFilter has shown errors of less than 0.1 % over the passband range. The comparison is also very close over the rest of the measurement range. Accuracy of this kind has proven to be typical for filters using the FPAA. Additionally, the present design works well for low frequency filters, especially for ranges between 0.007 Hz and 10 Hz, whereas previous techniques do not work as well in that range. Such frequency range is desirable for low frequency filters used for geologic work, biologic applications, and analysis of building structures.

This technique of filter design frees the designer to concentrate on the system requirements rather than spending effort on details such as component selection and fine tuning.

In compliance with the statute, the invention has been described in language more or less specific as to structural and methodical features. It is to be understood, however, that the invention is not limited to the specific features shown and described, since the means herein disclosed comprise preferred forms of putting the invention into effect. The invention is, therefore, claimed in any of its forms or modifications within the proper scope of the appended claims appropriately interpreted in accordance with the doctrine of equivalents.

## Claims

1. An apparatus for designing a filter to be rendered on a programmable circuit device capable of realizing at least one filter design by wiring together at least one filter component, comprising:
a programmable computing device;
a user interface associated with the programmable computing device; and
a design tool associated with the programmable computing device and configured for interaction with a user at the user interface, the design tool comprising computer program code embodied in the programmable computing device including at least one filter sub-circuit definition for rendering a filter design and containing information for defining at least one of multiple configurations, topologies, and parameters of the filter design via the at least one sub-circuit definition for a programmable circuit device;
wherein the user interface is configured to enable a user to select and apply input parameters to the filter design and dynamically receive display of at least one of filter response, poles required, and evaluation of sub-circuit parameters so a user can optimize input parameters for a desired filter design.

2. The apparatus of claim 1 wherein the user interface is configured to enable a user to select and apply filter specifications into filter design software.

3. The apparatus of claim 1 wherein the user interface is configured to enable a user to inspect a Bode plot filter performance prediction of the filter design.

4. The apparatus of claim 3 wherein the user interface is configured to enable a user to change at least one defining parameter for the Bode plot.

5. The apparatus of claim 4 wherein the user interface enables a user to view the changed Bode plot.

6. The apparatus of claim 4 wherein one defining parameter comprises ripple.

7. The apparatus of claim 4 wherein one defining parameter comprises overall gain.

8. The apparatus of claim 4 wherein one defining parameter comprises corner frequency.

9. The apparatus of claim 4 wherein one defining parameter comprises filter response.

10. The apparatus of claim 4 wherein one defining parameter comprises stop frequency.

11. The apparatus of claim 4 wherein one defining parameter comprises attenuation.

12. The apparatus of claim 4 wherein the defining parameter corresponds with a parameter line on a Bode plot, and a user drags the parameter line to a desired location on the Bode plot to apply a new input parameter to the filter design.

13. The apparatus of claim 12 wherein the user interface enables a user to dynamically view the parameter line and the Bode plot.

14. The apparatus of claim 12 wherein the parameter line corresponds with a CAM parameter limit.

15. A method of designing a circuit using a programmable circuit device, comprising:
providing a programmable computer with a user interface, a design tool and sub-circuit definitions for filter circuit components;
with the programmable computer and the user interface, generating a filter performance prediction;
applying one or more input parameters to the filter performance prediction via the user interface; and
displaying at least one of filter response, poles required, and evaluation of sub-circuit parameters in response to a change in input parameters.

16. The method of claim 15 further comprising inputting one of a filter specification and a filter parameter to the programmable computer using the user interface.

17. The method of claim 16 wherein the filter parameter comprises a configurable analog module (CAM) parameter limit.

18. The method of claim 17 wherein a plurality of configurable analog modules are wired together via the user interface to provide a filter design based upon the filter performance prediction.

19. The method of claim 15 wherein applying comprises implementing interactive computing drag and drop techniques via the user interface to apply the input parameters.

20. The method of claim 19 wherein implementing comprises modifying at least one input parameter.

21. The method of claim 20 further comprising generating a Bode plot in response to modifying at least one input parameter.

22. The method of claim 21 further comprising observing the Bode plot generated in response to modifying the at least one parameter.

23. The method of claim 22 wherein modifying and generating occur nearly simultaneously in time.

24. A method of synthesizing a circuit approximation, comprising:
providing a user interface, a programmable computing device, and a circuit design tool associated with the programmable computing device and configured to interact with a user via the user interface;
selecting a type of circuit to be synthesized;
selecting a circuit approximation;
rendering a circuit performance prediction via the design tool and programmable computing device based at least in part on a circuit parameter; and
dynamically interacting with the circuit performance prediction via the user interface to adjust the circuit parameter.

25. The method of claim 24 wherein selecting a type of circuit comprises selecting a type of filter, selecting a circuit approximation comprises selecting a filter approximation, and rendering comprises rendering a filter performance prediction.

26. The method of claim 25 wherein the filter performance prediction is correlated with at least one of a filter specification and a filter parameter.

27. The method of claim 26 further comprising entering a desired value for at least one of the filter specification and the filter parameter via the user interface to the design tool.

28. The method of claim 27 wherein dynamically interacting with the circuit performance prediction comprises observing performance of a new filter performance prediction resulting from entering the desired value.

29. The method of claim 27 wherein entering a desired value comprises dragging a filter parameter line on a Bode plot of the filter performance prediction to a desired value.

30. The method of claim 29 wherein the filter parameter line corresponds with at least one of ripple, overall gain, corner frequency, filter response, stop frequency, and attenuation on the Bode plot for the filter performance prediction.

31. The method of claim 27 wherein the filter specification is a graphical representation of the complex pole-zero plane.

32. The method of claim 31 wherein dynamically interacting with the circuit performance prediction comprises dragging the position of at least one of the poles and zeros in the graphical representation and observing the resultant filter performance prediction.

33. The method of claim 32 wherein the resultant filter performance prediction comprises at least one of a Bode plot and a step response plot in addition to the graphical representation of the complex pole-zero plane.

34. The method of claim 27 wherein the filter parameter is a step response plot represented in the time domain.

35. The method of claim 34 wherein dynamically interacting with the circuit performance prediction comprises dragging a filter parameter line on the step response plot.

36. The method of claim 35 wherein dragging the filter parameter line to a new position on the step response plot comprises manipulating position of a line which defines a desired limit of at least one of rise time, settling time, slew rate, decay rate, and overshoot.

37. The method of claim 25 wherein the type of filter comprises one of a low pass filter, a high pass filter, a band pass filter, and a band stop filter.

38. The method of claim 25 wherein the filter approximation comprises one of a Butterworth approximation, a Chebyshev approximation, an inverse Chebyshev approximation, an elliptic approximation, and a Bessel approximation.

39. The method of claim 24 wherein the circuit parameter is a graphical representation of a Nyquist limit of a clocked system.
